# EUROPEAN PATENT SPECIFICATION

(11) **EP 2 977 485 B1**
(45) Date of publication and mention of the grant of the patent: **08.05.2019**
(21) Application number: 14769428.5
(22) Date of filing: 03.03.2014
(51) Int. Cl.: C23C 14/50

(54) **PVD PROCESSING APPARATUS AND PVD PROCESSING METHOD**
PVD-VERARBEITUNGSVORRICHTUNG UND PVD-VERARBEITUNGSVERFAHREN
DISPOSITIF DE TRAITEMENT DE DÉPOSITION EN PHASE VAPEUR PAR PROCÉDÉ PHYSIQUE ET PROCÉDÉ DE TRAITEMENT DE DÉPOSITION EN PHASE VAPEUR PAR PROCÉDÉ PHYSIQUE

(30) Priority: 19.03.2013 JP 2013056771
(43) Date of publication of application: 27.01.2016
(73) Proprietor: Kabushiki Kaisha Kobe Seiko Sho (Kobe Steel, Ltd.), Kobe-shi, Hyogo 651-8585 (JP)
(72) Inventor: FUJII, Hirofumi, Takasago-shi, Hyogo 676-8670 (JP)
(74) Representative: TBK
(86) International application number: PCT/JP2014/001143
(87) International publication number: WO 2014/147979

(56) References cited:
- JP-A- 2003 266 243
- JP-A- 2004 307 920
- JP-A- 2012 224 878
- US-B2- 6 767 617

## Description

### Technical Field

The present invention relates to a PVD processing apparatus and PVD processing method.

### Background Art

With a view to enhancing wear and abrasion resistance of a cutting tool and enhancing sliding properties of a sliding surface of a mechanical component, a substrate (article) to be formed as a cutting tool or a mechanical component is subjected to coating formation, specifically, formation of a coating such as TiN, TiAIN or CrN, through a physical vapor deposition (PVD) process. As an apparatus for use in such coating formation known is a PVD processing apparatus including an arc ion plating (AIP) apparatus and a sputtering apparatus.

As such a PVD processing apparatus, there has been known a type of forming a composite coating by a combination of a plurality of different PVD processes. For example, there has been known a type of forming a hard coating on a surface of a substrate (article) by an arc ion plating process and then forming a lubricating coating on the hard coating by a sputtering device. Thus alternately using a plurality of types of PVD processes enables a composite coating to be formed on the surface of the substrate.

For example, the following Patent Literature 1 discloses a PVD processing apparatus which comprises: a chamber containing therein both of a sputtering vaporization source and a vacuum arc vaporization source; a substrate holder; and a shutter for shuttering, during use of one of the two vaporization sources, the other vaporization source, wherein a plurality of types of coatings on a substrate can be formed by sequential restriction of the use of the two vaporization sources or simultaneous use of the two vaporization sources. In this PVD processing apparatus, the two vaporization sources are arranged such that respective targets of the vaporization sources are oriented in the same direction. The substrate holder holds the substrate at such a position that the substrate is spaced apart from each of the targets of the vaporization sources by a constant distance and rotates the substrate. The rotated substrate can be displaced from a position in front of one of the targets to a position in front of the other target, thereby allowing coating formation to be performed in front of each of the targets alternately to form a composite coating.

The Patent Literature 2 discloses a PVD processing apparatus which comprises: a vacuum chamber containing therein both of a sputtering vaporization source and a vacuum arc vaporization source; and a cylindrical jig provided inside the vacuum chamber, the jig having a peripheral surface on which a substrate is mounted. In this apparatus, the revolution (rotation) of the jig allows the two vaporization sources to be sequentially used, thereby enabling a plurality of types of thin coatings to be formed on the surface of the substrate.

According to the PVD processing apparatuses disclosed in the Patent Literatures 1 and 2, it is possible to form a coating having a uniform thickness if the subject of the coating formation be a flat-plate-shaped substrate, but it is difficult to form a coating on an outer peripheral surface of a cylindrical-shaped member, such as a drill or a tip. That is because the coating formation on the outer peripheral surface of the cylindrical-shaped member requires the member, i.e., the substrate, to rotate on its own axis, but the PVD processing apparatus disclosed in either of the Patent Literatures 1 and 2 is provided with no mechanism for rotating the substrate. That is why the PVD processing apparatus disclosed in either of the Patent Literatures 1 and 2 is incapable of adequate coating formation on such a member as mentioned above.

Even the above PVD processing apparatus, however, could perform the above composite coating on the thus shaped substrate if being modified, for example, not only to revolve but also to rotate the substrate on its own axis during the coating formation. For example, the above composite coating would be enabled to be formed on the substrate by: providing a revolving table capable of revolution around a revolution axis in a vacuum chamber; providing a rotating table capable of rotating about its axis parallel to the revolution axis on the revolving table; placing a substrate on the rotating table to make the substrate revolve and rotate on its own axis; and providing a plurality of different types of vaporization sources radially outside the revolving table.

However, even in the case of revolving and rotating a substrate by use of a mechanism with the above-mentioned revolving and rotating function, there can remain a problem of failing to obtain a homogeneous composite coating if a rotation ratio (gear ratio) of the rotating of the rotating table to the revolution of the revolving table is not set to an adequate value. For example, setting the rotation ratio of the rotating table to the revolving table to an adequate value enables a composite coating having a cross-sectional shape with a plurality of concentrically laminated circular ring-shaped coating layers, whereas, failing to set the rotation ratio of the rotating table to the revolving table to an adequate value may cause a composite coating with an inhomogeneous structure to be formed. Specifically, it generates a possibility that such a C-shaped coating that a circumferentially part of a circular ring is lacking is included in a composite coating, or a possibility of causing some circular ring-shaped coating layers only respective circumferential part of which overlap each other.

Patent Literature 3 discloses method for the manufacture of an article having first and second surface regions of different coefficients of friction in a treatment chamber with a rotary support for the articles and capable of simultaneously carrying out at least two PVD coating processes. The first PVD coating process is carried out with a comparatively directed vapor flux from one or more targets which can compose one or more of the elements B, Si, Ti, V, Cr, Zr, Nb, Mo, Hf, Ta and W, carbides of these elements and carbon. A second PVD coating process is carried out with a comparatively less directed or non-directed vapor flux of carbon.

### Citation List

### Patent Literature

Patent Literature 1: JP 11-200042 A
Patent Literature 2: JP 2 836 876 B
Patent Literature 3: US 6 767 617 B2

### Summary of Invention

To address the above problems the invention provides a PVD processing apparatus according to claim 1 and a PVD processing method according to claim 3 capable of forming a good composite coating on an outer peripheral surface of a substrate through the rotation and the revolution of the substrate.

Provided is a PVD processing apparatus for performing coating formation on respective surfaces of a plurality of substrates, the PVD processing apparatus comprising: a vacuum chamber containing therein the plurality of substrates; a revolving table provided in the vacuum chamber and configured to support the plurality of substrates and to revolve the supported substrates around a revolution axis; a plurality of rotating tables configured to support respective substrates of the plurality of substrates and rotating the supported substrates, on the revolving table, about their respective rotation axes parallel to the revolution axis; a plurality of targets formed of respective different types of coating-formation materials, the targets disposed at respective positions circumferentially spaced on radial outside of the revolving table; and a table rotating mechanism for rotating each of the rotating tables about its rotation axis in synchronization with the rotation of the revolving table. The table rotating mechanism is configured to rotate the rotating table, on which the substrate is placed, about its rotation axis by an angle of 180° or more relatively to the revolving table, while the substrate passes through a region between two tangent lines drawn from a center of each of the targets to an arc enveloping the rotating tables.

Also provided is a PVD processing method for coating formation on respective surfaces of a plurality of substrates, the PVD processing method comprising: preparing a vacuum chamber containing therein the plurality of substrates, a revolving table provided in the vacuum chamber and configured to support the plurality of substrates and to revolve the supported substrates around an revolution axis, and a plurality of targets formed of respective different types of coating-formation materials, the targets disposed at respective positions circumferentially spaced on radial outside of the revolving table; and performing PVD processing involving rotating each of the substrates about its rotation axis by an angle of 180° or more relatively to the revolving table while the substrate passes through a region between two tangent lines drawn from a center of each of the targets to an arc enveloping each of the substrates.

### Brief Description of Drawings

FIG. 1 is a top plan view of a PVD processing apparatus according to an embodiment of the present invention.
FIG. 2A is a top plan view showing a state of coating formation on a substrate with no rotation of each rotating table in the PVD processing apparatus on its axis.
FIG. 2B is a top plan view showing a state of coating formation on a substrate with respective rotations of rotating tables in the PVD processing apparatus on their respective axes.
FIG. 3A is a perspective view showing an appearance of a substantial part of a PVD processing apparatus used in each of an inventive example and a comparative example.
FIG. 3B is a top plan view of the essential part of the apparatus shown in FIG. 3A.
FIG. 4A is a top plan view showing a table rotating mechanism in the inventive example.
FIG. 4B is a top plan view showing a table rotating mechanism in the comparative example.
FIG. 5A is a graph showing a result of coating thickness measurement according to the inventive example.
FIG. 5B is a graph showing a result of coating thickness measurement according to the comparative example.
FIG. 6A is a sectional top plan view showing a composite coating formed on an outer peripheral surface of a substrate in an inventive example.
FIG. 6B is a sectional top plan view showing a composite coating formed on an outer peripheral surface of a substrate in a conventional example.
FIG. 7 is a sectional top plan view showing a composite coating formed on an outer peripheral surface of a substrate in an inventive example, respective circumferential parts of some coating layers of the composite coating overlapping.

### Description of Embodiments

With reference to the drawings, there will be described a PVD processing apparatus 1 according to an embodiment of the present invention. The PVD processing apparatus 1 according to the embodiment is designed to perform formation of composite coating on a surface of a substrate W by use of two or more types of PVD processes or by alternate or simultaneous use of two or more types of targets in the same type of PVD process. In the PVD processing apparatus 1 according to the below-described embodiment, performed is formation of a composite coating by use of both of arc ion plating process and sputtering process included in various PVD processes.

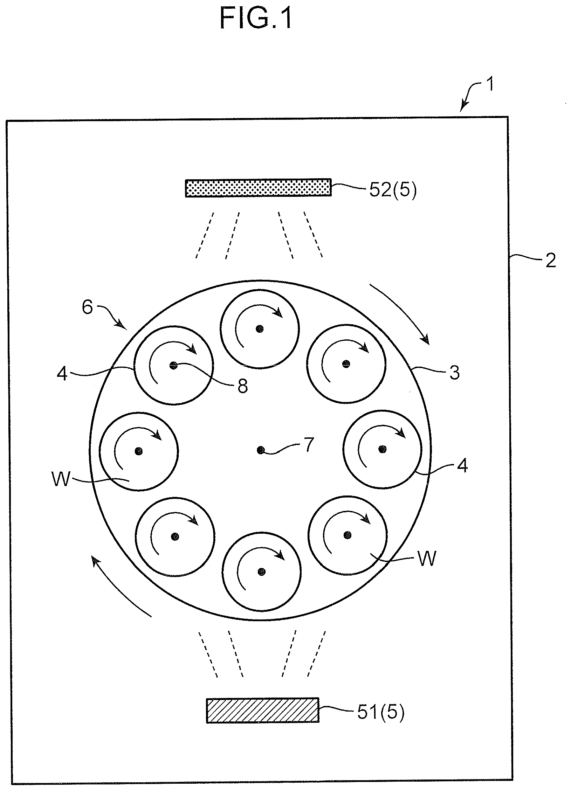

FIG. 1 is a top plan view showing the PVD processing apparatus 1 according to this embodiment. The PVD processing apparatus 1 comprises a vacuum chamber 2, a revolving table 3, a plurality of rotating tables 4, a plurality of targets 5, and a table rotating mechanism 6. The vacuum chamber 2 encloses a processing space which can be evacuated to a vacuum or an extremely low pressure by use of a non-shown vacuum pump or the like. The revolving table 3, the plurality of rotating tables 4, the plurality of targets 5 and the table rotating mechanism 6 are contained in the vacuum chamber 2. The revolving table 3 supports the plurality of substrates W and revolves the supported substrates W. The rotating tables 4 support respective substrates W of the plurality of substrates and rotates the supported substrate W on the revolving table 3. The targets 5 are formed of respective different types of coating-formation materials and disposed at respective positions circumferentially spaced on radial outside of the revolving table 3. The table rotating mechanism 6 rotates the revolving table 3 and each of the rotating tables 4 at a given gear ratio.

As shown in FIG. 1, the revolving table 3 is a disk-shaped member capable of involving the plurality of substrates W around the revolution axis 7 through rotating itself about the revolution axis 7 while supporting the substrates W. In the graphically shown example, the revolution axis 7 is set to one extending vertically in the vacuum chamber 2. The rotating tables 4 are disposed at respective (eight in the shown embodiment) positions circumferentially spaced near the outer periphery of the revolving table 3 and support the substrates W, respectively. The table rotating mechanism 6 is provided under the revolving table 3 and rotates the revolving table 3 about the revolution axis 7, for example, clockwise in top plan view, as indicated by the arrowed lines in FIG. 1, thereby revolving the substrates around the revolution axis 7 W clockwise.

Each of the rotating tables 4 is a disk-shaped member with an outer diameter less than an outer diameter of the revolving table 3, having an upper surface allowing the substrate W, which is a cylindrical-shaped shaped, conical-shaped or disk-shaped member, to be placed thereon. Each of the rotating tables 4 is driven by the table rotating mechanism 6 so as to rotate about its rotation axis 8 parallel to the revolution axis 7. The substrate W to be placed on each of the rotating tables 4 is an article having an outer peripheral surface circularly curved along a circumferential direction thereof, such as a drill or a tip, the curved outer peripheral surface allowing a coating to be formed thereon. The substrate W in this embodiment is a cylindrical-shaped article; however, the substrate which is subject of coating formation according to the present invention is not limited to a cylindrical-shaped one. For example, the term "substrate" herein includes a conical-shaped member with a sharp-pointed tip, and a substrate assembly including a plurality of disk-shaped members stacked to form a cylindrical contour as a whole.

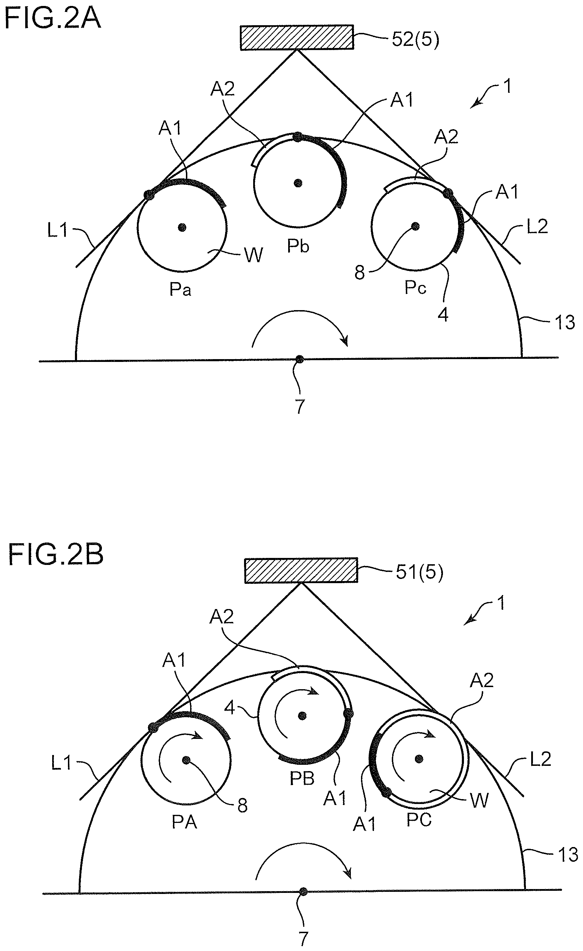

Each of the targets 5 is made of a material serving as a raw material for a coating, such as Ti, Al, Ni and C, formed into a plate shape in this embodiment. The plurality of targets 5 include a target for arc ion plating and a target for sputtering, being formed of respective different types of coating-formation materials. The target 51 for arc ion plating and the target 52 for sputtering are disposed at respective positions spaced circumferentially of the revolving table 3 on radial outside of the revolving table 3. In the graphically shown example, the target 52 for sputtering is disposed on one lateral side of the revolving table 3 (on the upper side in the drawing sheet of FIG. 1) and the target 51 for arc ion plating is disposed on the other lateral side opposite to the target 52 for sputtering across the revolution axis 7 (on the lower side in the drawing sheet of FIG. 2).

The table rotating mechanism 6 distributes a rotational driving force generated by a non-shown drive motor to the revolving table 3 and the rotating tables 4, thereby rotating the two types of tables 3, 4 at a given gear ratio.

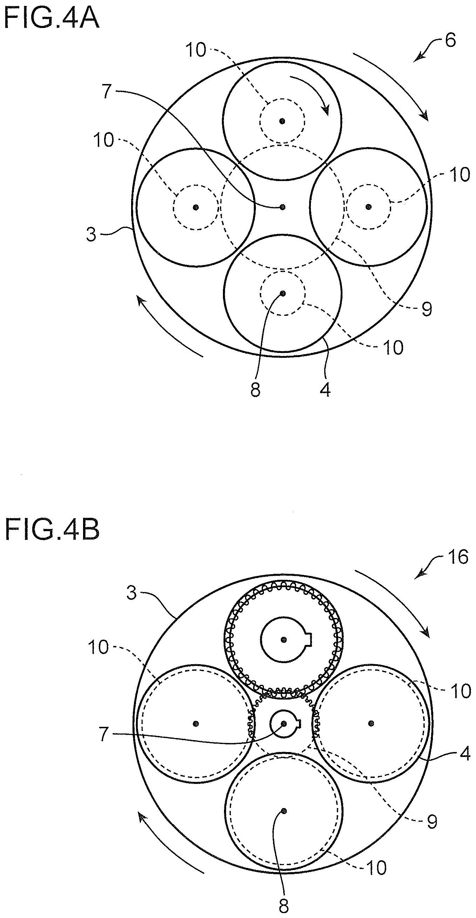

The PVD processing apparatus 1 shown in FIG. 1 includes eight of the rotating tables 9 mounted on the revolving table 3, whereas FIG. 4A shows a table rotating mechanism 6 in an inventive example including four rotating tables 9 mounted on one revolving table 3 and FIG. 4B shows a table rotating mechanism 16 in a comparative example with respect to the inventive example.

Specifically, each of the table rotating mechanisms 6, 16 includes a central gear 9 provided on the revolving-table-3 side, and a plurality of rotating gears 10 provided on respective rotating-table-4 sides. The central gear 9 and each of the rotating gears 10 are meshed with each other in the circumferential arrangement of the rotating gears 10 around the central gear 9. As shown in FIG. 4A and FIG. 4B, changing the outer diameter and/or the number of teeth of a gear to be used as each of the gears 9, 10 enables each of the rotating table 4 to be rotated (i.e., rotated on its rotation axis) relatively to the revolving table 3 at various gear ratios. The central gear 9 shown in FIG. 4A is a large-diameter gear while each of the rotating gears 10 meshed with the central gear 9 is a small-diameter gear having a smaller diameter than that of the central gear 9. The central gear 9 shown in FIG. 4B is a small-diameter gear while each of the rotating gears 10 meshed with the central gear 9 is a large-diameter gear having a diameter greater than that of the central gear 9.

The table rotating mechanism 6 is given a gear ratio of the central gear 9 to each of the rotating gears 10 such that each of the rotating table 4 on which the substrate W is placed rotates about its rotation axis by an angle of 180° or more relatively to the revolving table 3, while each of the substrates W passes through the region between two tangent lines L1, L2 drawn from a center of each of the targets 5, namely, each of the targets 51, 52, more specifically, a widthwise center of one of opposite surfaces of the target facing the revolving table 3, the widthwise center being a center with respect to a direction perpendicular to the revolution axis, to an arc enveloping the rotating tables 4, preferably, an arc 13 enveloping the outer peripheral surfaces of the substrates W supported by the respective rotating tables 4, as shown in FIG. 2A and FIG. 2B. In other words, the gear ratio is determined such that each of the rotating tables 4 rotates about its rotation axis by an angle of 180° or more relatively to the revolution coordinate system set on the revolving table, while each of the substrates W passes through the region between the tangent lines L1, L2,.

The central gear 9 according to this embodiment is disposed under the revolving table 3 and fixed to a table base other than the revolving table 3 so as to permit the revolving table 3 to rotate relatively to the central gear 9. The central gear 9 has teeth arrangement around the revolution axis 7. The rotating gears 10 are arranged around the central gear 9 while meshed with the central gear 9. Each of the rotating gears 10 are supported by the revolving table 3 so as to be rotatable integrally with the respective rotating tables 4 about their respective rotation axes 8. The revolving table 3 is driven to be rotated by the aforementioned drive motor, involving the rotational drive of each of the rotating tables 4 coupled to the central gear 9 via the respective rotating gears about their respective rotation axes 8. In other words, each of the revolving table 3 and the rotating tables 4 are rotated wherein each of the rotating gears 10 is applied with the rotational driving force from the not-graphically-shown drive motor to be thereby moved along an outer periphery of the central gear 9 by use of the applied rotational driving force.

For PVD processing of a plurality of substrates W by use of the PVD processing apparatus 1 with the configuration shown in FIG. 1, the substrates W are first placed on the respective rotating tables 4. Then, the revolving table 3 is driven to be rotated about the revolution axis 7 by use of a rotational driving force produced by a drive motor. This rotational driving force is also transmitted to the rotating tables 4 via the table rotating mechanism 6, rotating the rotating tables 4 about their respective rotation axes 8 following the rotation of the revolving table 3. This causes each of the substrates W placed on the respective rotating tables 4 to revolve around the revolution axis 7 while rotating about their respective rotation axes 8.

The table rotating mechanism 6, meanwhile, rotates the substrates W and the rotating tables 4 supporting the substrates W, respectively, about their respective rotation axes by an angle of 180° or more, relatively to the revolving table 3, while each of the substrates W passes through the region between the two tangent lines L1, L2 drawn from the center of each of the plurality of targets 5, namely, the targets 51, 52 in this embodiment, to the arc 13 enveloping the rotating tables 4. The reason why such a rotation angle should be set will be described with reference to the PVD processing apparatus 1 shown in FIGS. 1 and 2.

From a center of an electrode surface of the target 52 for sputtering, a coating-formation material is scattered while spreading in a spray-like pattern, toward the revolving table 3 (toward the revolution-axis-7 side). More specifically, the coating-formation material spattered from the target 52 for sputtering is scattered so as to spread in a fan-like or sector shape, in a direction from the center of the electrode surface to the revolving table 3, as shown in FIG. 2A and FIG. 2B. In this process, the material is scattered in the largest amount in front of the target 52 for sputtering, and the amount of the scattered material decreases with an increase in angle with a line perpendicular to the target 52. The range of scattering of the material from the target 52 for sputtering expands over all frontward directions, and the material which is scattered in a range between a first one L1 of the two tangent lines and the other, second, tangent line L2 with respect to an the arc 13 enveloping the rotating tables 4 forms a coating on a surface of the substrate W, while each of the substrates W passes through the scattered material.

Below will be described about the case of no rotation of each of the rotating tables 4 as shown in FIG. 2A. Even in this case, each of the rotating tables 4 and the substrates W makes their revolutions, which brings one point (indicated by the ● mark in FIG. 2A) existing on the outer peripheral surface of the substrate W into the region between the two tangent lines L1, L2. In short, the point indicated by the ● mark comes to the position Pa shown in FIG. 2A. From this point in time, the coating-formation material scattered from the target 52 for sputtering is allowed to reach the outer peripheral surface of the substrate W, thus deposited to form a coating in an arc-shaped region A1 blacked-out in Fig. 2A.

Even in the region between the two tangent lines L1, L2, a specific part of the outer peripheral surface of the substrate W can be hidden from the target 52 for sputtering behind the substrate W itself until the specific part reaches the position Pa, which prevents any coating from being formed on the surface of the specific part.

The rotation of the revolving table 3 causes the revolution of the substrate W, the revolution changing the relative position of the substrate W to each of the targets 5 on a horizontal plane. Thus, the substrate W provided on the revolving table 3 has a changing position in an absolute coordinate system relatively to each of the targets 5, even when the substrate W makes no rotation on its axis, which causes also a position where the coating-formation material will be deposited on the outer peripheral surface of the substrate W to be varied on the outer peripheral surface.

For example, the deposition of the coating-formation material can be discussed with a focus on a specific point on the outer peripheral surface of the substrate W, as follows. The rotation of the revolving table 3 moves the specific point indicated by the ● mark in FIG. 2A to the positions Pa, Pb, Pc in FIG. 2A sequentially, that is, moves the specific point from a position on the first tangent line L1 to a position on the second tangent line L2 via a position in front of the target 5. When the relative position of the substrate W to the target 5 is thus changed to reach the position Pc, the coating-formation material can be deposited also in a position adjacent to the blacked-out region, thereby forming a coating not only in the blacked-out region A1 but also in the outlined region A2.

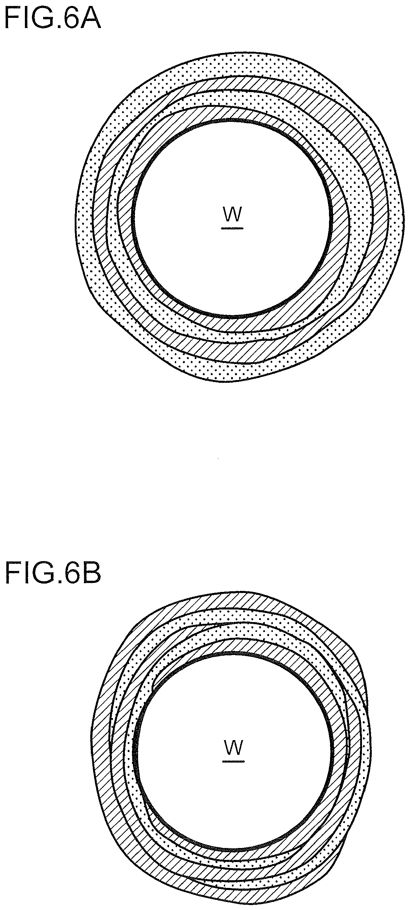

As described above, no rotation of each of the substrates W generates no possibility of covering the entire outer peripheral surface of the substrate W even with the combination of the coating on the blacked-out region A1 and the coating on the outlined region A2 shown in FIG. 2A. This can cause, in the case shown in FIG. 2A, a coating layer lacking a circumferentially part thereof to be formed on the outer peripheral surface of the substrate W, for example, as shown in FIG. 6B.

In contrast, the rotation of each of the rotating tables 4 on its axis by a sufficient angle, as shown in FIG. 2B, involved by the rotation of the revolving table 3 enables the combination of the coating on the blacked-out region A1 and the coating on the outlined region A2 to cover the entire outer peripheral surface of the substrate W, thus allowing a composite coating having a homogenous structure to be formed on the outer peripheral surface of the substrate W, for example, as shown in FIG. 6A. Specifically, it is preferable to determine such a gear ratio of each of the rotating gears 10 to the revolution gear 9 of the table rotating mechanism 6 of the table rotating mechanism 6 as to enable each of the rotating tables 10 to rotate by an angle of 180° or more, relatively to the revolving table 3, while each of the substrates W passes through the region between the two tangent lines L1, L2. Thus determined gear ratio enables the rotating table 4 to rotate over an increased angle to allow the range of the coating on the outlined region A2 to be widen, thereby making it possible to form a seamless continuous coating over the entire circumference of the outer peripheral surface of the substrate W.

For example, in the case where the point indicated by the ● mark in FIG. 2B reaches the position PC via the position PA and the position PB in FIG. 2B, a coating can be formed, in the position PC, on the outer peripheral surface of the substrate W over a region wider than the outlined region A2 shown in FIG. 2A by 180°. This means that the combination of the coating on the blacked-out region A1 and the coating on the outlined region A2 can cover the entire outer peripheral surface of the substrate W. This allows a seamless continuous coating to be formed over the entire circumference of the outer peripheral surface of the substrate W as shown in FIG. 6A, that is, allows a coating with a homogenous structure to be formed on the outer peripheral surface of the substrate W.

Although the above embodiment uses the target 52 for sputtering to form a circumferentially seamless continuous coating, operating the table rotating mechanism 6 so as to satisfy the aforementioned relationship with the target 51 for arc ion plating also makes it possible to form a circumferentially seamless continuous coating, that is, a composite coating having a homogenous structure, on the outer peripheral surface of the substrate W.

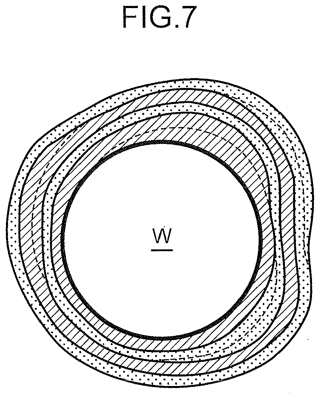

However, even when a seamless continuous coating can be formed over the entire circumference of the outer peripheral surface of the substrate W, there remains possibility of partial overlap of an initially-formed coating layer and a lastly-formed coating layer in a composite coating, as shown in FIG. 7, which may cause unevenness in coating thickness to make it difficult to form a composite coating with a homogenous structure.

Against this, it is preferable to set the gear ratio which allows the rotating table 4 on which the substrate W is placed to rotate by an angle of 360° or more, preferably, an angle of 720° or more, relatively to the revolving table 3 while each of the substrates W passes through the region between the two tangent lines L1, L2. This suppresses the unevenness in coating thickness to allow a composite coating with a more homogenous structure to be formed. Specifically, regarding the rotation angle that is an angle by which the rotating table 4 rotates relatively to the revolving table 3 while the substrate W passes through the region between the two tangent lines L1, L2, the rotation angle of 180° permits about ± 50% of a variation in coating thickness to occur, whereas the rotation angle of 360° reduces the variation to about ± 30%, and, furthermore, the rotation angle of 720° reduces the variation to about ± 10%.

### Examples

Next will be described effects of the PVD processing method of the present invention, more specifically, based on an inventive example and a comparative example.

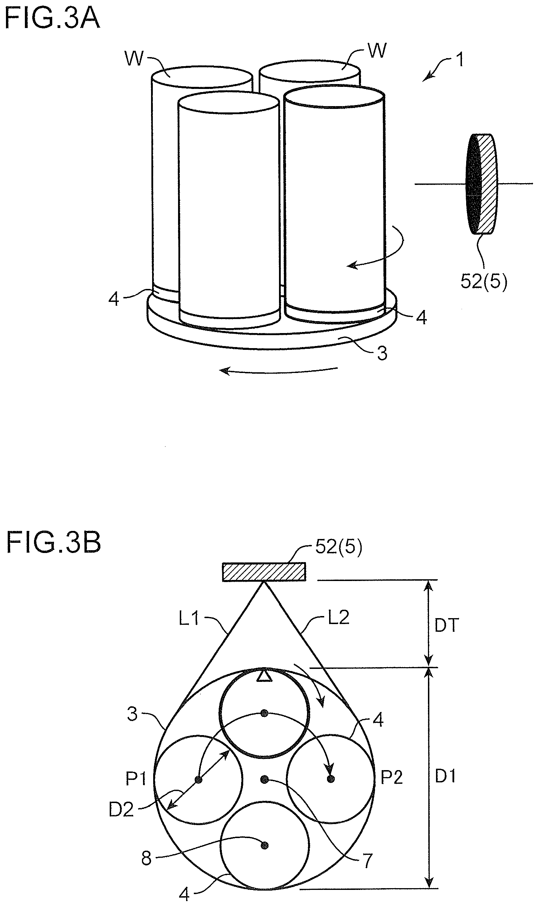

There is used in experiments a PVD processing apparatus 1 shown in FIGS. 3A and 3B, employing a revolving table 3 having an outer diameter D1 of 400 mm and four rotating tables 4 each having an outer diameter D2 of 160 mm ϕ, wherein the rotating tables 4 are spaced uniformly and circumferentially of the revolving table 3, on the revolving table 3. Each of the rotating tables 4A allows a substrate W to be formed thereon, the substrate W being a cylindrical body with a diameter of 160 mm ϕ. In the inventive and comparative examples, coating formation is performed on an outer peripheral surface of the substrate W by an arc ion plating process.

A target 51 is used for the arc ion plating process, the target 51 being a circular plate with a diameter of 100 mm and disposed at a position radially outward away from an outer peripheral edge of the revolving table 3 by a distance DT of 160 mm. Coating formation is performed through supply of an arc current of 150A to the target 51 for arc ion plating and supply of nitrogen gas into a processing space in a vacuum chamber 2 until the pressure in the processing space reaches 3 Pa.

In the inventive and comparative examples, a central gear 9 is provided for the revolving table 3 while a rotating gear 9 is provided for each of the rotating table 4, and the gear ratio of the rotating gear 10 of the central gear 9 in the inventive example is different from that of the comparable example. These gear ratios are presented in Table 1. In the table rotating mechanism 6 in the inventive example shown in FIG. 4A, each of four rotating gears 10 having a diameter of 60 mm ϕ rotates on its own axis and revolves while being meshed with the central gear 9 having a diameter of 180 mm ϕ, wherein the rotation angle of the rotating gear 10 with respect to the revolution coordinate system is 337.5°. In the table rotating mechanism 16 in the comparative example shown in FIG. 4B, each of four rotating gears having a diameter of 150 mm ϕ rotates on its own axis and revolves while being meshed with the central gear 9 having a diameter of 90 mm ϕ, wherein the rotation angle of the rotating gear with respect to the revolution coordinate system is 67.5°.

**TABLE 1**

| | Inventive Example | Comparative Example |
|---|---|---|
| Diameter of central gear | 90 mm ϕ | 180 mm ϕ |
| Diameter of rotating gear | 150 mm ϕ | 60 mm ϕ |
| Angle by which rotating table rotates relatively to revolving table during passing through region between two tangent lines | 67.5° | 337.5°. |

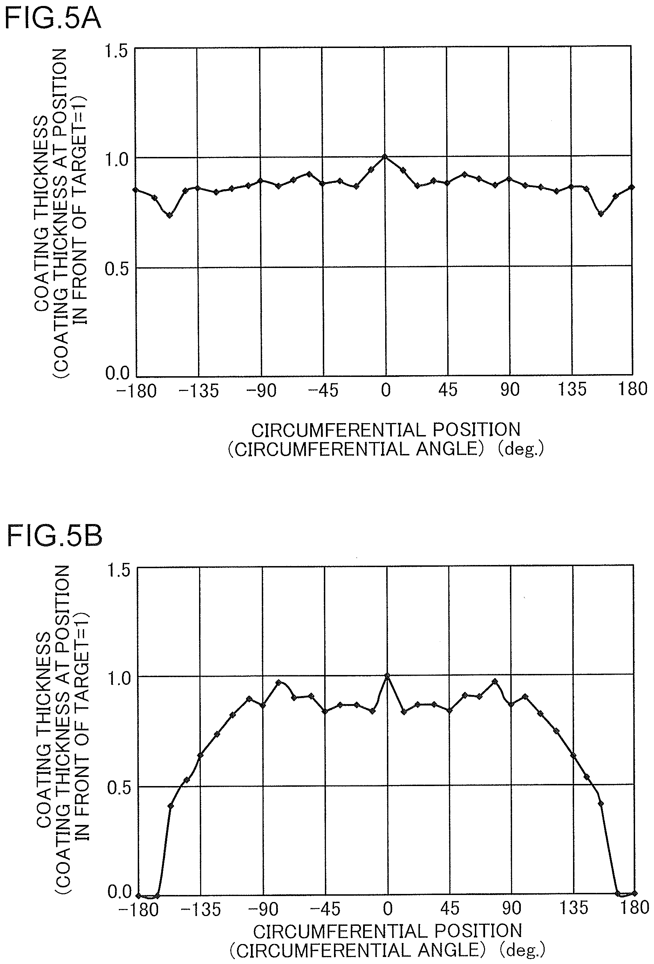

In the above inventive and comparative examples, measured is a thickness of a coating formed on a surface of the substrate W while the substrate W revolves over 180° from the position PI to the position P2 in FIG. 3B. FIGS. 5A and 5B present respective results of the coating thickness measurement for the inventive and comparative examples. FIGS. 5A and 5B indicates values of the coating thickness on the vertical axis, each value being relative to a thickness of a coating formed when the substrate is located in front of one of the targets 5, and indicates a circumferential position on the horizontal axis which position is expressed as an angle on an assumption that the circumferential position when the substrate W is in front of each of the targets 5 is 0°.

As shown in FIG. 5A, the thickness of the coating formed in the inventive example varies within the range of 0.7 to 1.0, in an angular range of the circumferential position of - 180° to + 180°; therefore, no significant variation in the coating thickness occurs even when the circumferential position is changed. In contrast, as shown in FIG. 5B, the thickness of the coating formed in the comparative example is sharply reduced when the circumferential position is in the range of - 180° to - 100° and in the range of + 100° to + 180°; therefore, there occurs significant variation in the coating thickness. Besides, the coating thickness at the circumferential position around - 180° or around + 180° is reduced to about 0, which indicates almost no existence of coating formation therein.

This shows that rotating each of the rotating tables 4 by an angle of 180° or more relatively to the revolving table 3 while each of the substrates W passes through the region between the two tangent lines L1, L2 makes it possible to form a seamless continuous coating over the entire circumference of the outer peripheral surface of the substrate W to thereby form a composite coating having an excellent coating thickness uniformity, on the outer peripheral surface of the substrate W.

It should be noted that the present invention is not limited to the above embodiment and examples, but various changes and modifications may be made therein in terms of shape, structure, material, combination, etc., of each component, without departing from the spirit and scope of the invention hereinafter defined. Further, as regards matters which are not explicitly disclosed in the above embodiment, such as operating and processing conditions, various parameters, and size, weight and volume of each component, any value easily assumable to a person having ordinary skill in the art may be employed without departing from a range usually implemented by a persons skilled in the art.

As above, the present invention provides a PVD processing apparatus and a PVD processing method capable of forming a good composite coating on an outer peripheral surface of a substrate through the rotation and revolution of the substrate.

Provided by the present invention is a PVD processing apparatus for performing coating formation on respective surfaces of a plurality of substrates, the PVD processing apparatus comprising: a vacuum chamber containing therein the plurality of substrates; a revolving table provided in the vacuum chamber and configured to support the plurality of substrates and to revolve the supported substrates around a revolution axis; a plurality of rotating tables configured to support respective substrates of the plurality of substrates and rotating the supported substrates, on the revolving table, about their respective rotation axes parallel to the revolution axis; a plurality of targets formed of respective different types of coating-formation materials, the targets disposed at respective positions circumferentially spaced on radial outside of the revolving table; and a table rotating mechanism for rotating each of the rotating tables about its rotation axis. The table rotating mechanism is configured to rotate the rotating table, on which the substrate is placed, about its rotation axis by an angle of 180° or more relatively to the revolving table while the substrate passes through a region between two tangent lines drawn from a center of each of the targets to an arc enveloping the rotating tables.

Also provided is a PVD processing method for performing coating formation on respective surfaces of a plurality of substrates, the PVD processing method comprising: preparing a vacuum chamber containing therein the plurality of substrates, a revolving table provided in the vacuum chamber and configured to support the plurality of substrates and to revolve the supported substrates around an revolution axis, and a plurality of targets formed of respective different types of coating-formation materials, the targets disposed at respective positions circumferentially spaced on radial outside of the revolving table; and performing PVD processing involving rotating each of the substrates about its rotation axis by an angle of 180° or more relatively to the revolving table while the substrate passes through a region between two tangent lines drawn from a center of each of the targets to an arc enveloping each of the substrates.

According to the above PVD processing apparatus and method, the rotation of the substrate on its axis by an angle of 180° or more relatively to the revolving table while the substrate passes through the region between the two tangent lines allows a coating having excellent uniformity to be formed on the outer peripheral surface of the substrate. This allows a composite coating having an excellent coating thickness uniformity to be formed on the outer peripheral surface of the substrate.

For example, it is preferable that the table rotating mechanism of the PVD processing apparatus includes: a central gear having teeth arrangement around the revolution axis, the central gear fixed so as to permit the revolving table to rotate relatively to the central gear; and a plurality of rotating gears configured to rotate integrally with the respective rotating tables about their respective rotation axes, the rotating gears being arranged around the central gear while meshed with the central gear so as to allow the rotating gears to rotate on their respective rotation axes in synchronization with the rotation of the revolving table about the revolution axis. In this case, it is more preferable to set a gear ratio of the central gear to each of the rotating gears such that the rotating table on which the substrate is placed rotates on its rotation axis by an angle of 180° or more relatively to the revolving table while the substrate passes through a region between the two tangent lines.

## Claims

1. A PVD processing apparatus (1) for performing coating formation on respective surfaces of a plurality of substrates (W), the PVD processing apparatus (1) comprising:
a vacuum chamber (2) containing therein the plurality of substrates (W);
a revolving table (3) provided in the vacuum chamber (2) and configured to support the plurality of substrates (W) and to revolve the supported substrates (W) around a revolution axis (7);
a plurality of rotating tables (4) configured to support respective substrates (W) of the plurality of substrates (W) and rotating the supported substrates (W), on the revolving table (3), about their respective rotation axes parallel to the revolution axis (7); and
a plurality of targets (5) formed of respective different types of coating-formation materials, the targets disposed at respective positions circumferentially spaced on radial outside of the revolving table (3);
**characterized by**
a table rotating mechanism (6) for rotating each of the rotating tables (4) about its rotation axis, the table rotating mechanism (6) configured to rotate the rotating table, on which the substrate (W) is placed, about its rotation axis by an angle of 180° or more relatively to the revolving table (3) while the substrate (W) passes through a region between two tangent lines (L1, L2) drawn from a center of each of the targets (5) to an arc (13) enveloping the rotating tables (4),
wherein the respective substrates (W) are cylindrical-shaped, conical-shaped or disk-shaped members.

2. The PVD processing apparatus (1) as recited in claim 1, wherein the table rotating mechanism (6) of the PVD processing apparatus (1) includes:
a central gear (9) having teeth arrangement around the revolution axis (7), the central gear (9) fixed so as to permit the revolving table (3) to rotate relatively to the central gear (9); and
a plurality of rotating gears (10) configured to rotate integrally with the respective rotating tables (4) about their respective rotation axes, the rotating gears (10) being arranged around the central gear (9) while meshed with the central gear (9) so as to allow the rotating gears (10) to rotate on their respective rotation axes in synchronization with the rotation of the revolving table (3) about the revolution axis (7), and a gear ratio of the central gear (9) to each of the rotating gears (10) is set such that the rotating table on which the substrate (W) is placed rotates on its rotation axis by an angle of 180° or more relatively to the revolving table (3) while the substrate (W) passes through a region between the two tangent lines (L1, L2).

3. A PVD processing method for performing coating formation on respective surfaces of a plurality of substrates (W), the PVD processing method comprising:
preparing a vacuum chamber (2) containing therein the plurality of substrates (W), a revolving table (3) provided in the vacuum chamber (2) and configured to support the plurality of substrates (W) and to revolve the supported substrates (W) around an revolution axis (7), and a plurality of targets (5) formed of respective different types of coating-formation materials, the targets disposed at respective positions circumferentially spaced on radial outside of the revolving table (3);
**characterized by**
performing PVD processing involving rotating each of the substrates (W) about its rotation axis by an angle of 180° or more relatively to the revolving table (3) while the substrate (W) passes through a region between two tangent lines (L1, L2) drawn from a center of each of the targets to an arc enveloping each of the substrates (W),
wherein the respective substrates (W) are cylindrical-shaped, conical-shaped or disk-shaped members.

## Patentansprüche

1. PVD-Verarbeitungsvorrichtung (1) zum Durchführen einer Beschichtungsbildung auf entsprechenden Oberflächen einer Vielzahl von Substraten (W), wobei die PVD-Verarbeitungsvorrichtung (1) umfasst:
eine Vakuumkammer (2), die darin die Vielzahl von Substraten (W) enthält;
einen Umlauftisch (3), der in der Vakuumkammer (2) vorgesehen und konfiguriert ist, um die Vielzahl von Substraten (W) zu tragen und die getragenen Substrate (W) um eine Umlaufachse (7) zu umlaufen;
eine Vielzahl von Rotationstischen (4), die konfiguriert sind, um jeweilige Substrate (W) der Vielzahl von Substraten (W) zu tragen und die getragenen Substrate (W) auf dem Umlauftisch (3) um ihre jeweiligen Drehachsen parallel zur Drehachse (7) zu drehen; und
eine Vielzahl von Zielen (5), die aus jeweils verschiedenen Arten von Beschichtungsbildungsmaterialien gebildet sind, wobei die Ziele an jeweiligen Positionen angeordnet sind, die in Umfangsrichtung auf radialer Ebene außerhalb des Umlauftisches (3) beabstandet sind;
**gekennzeichnet durch**
einen Tischdrehmechanismus (6) zum Drehen jedes der Umlauftische (4) um seine Drehachse, wobei der Tischdrehmechanismus (6) konfiguriert ist, um den Rotationstisch, auf dem das Substrat (W) angeordnet ist, um seine Drehachse um einen Winkel von 180° oder mehr relativ zum Umlauftisch (3) zu drehen, während das Substrat (W) durch einen Bereich zwischen zwei Tangentiallinien (L1, L2) verläuft, die von einer Mitte jedes der Ziele (5) zu einem Bogen (13) gezogen werden, der die Rotationstische (4) umgibt,
wobei die jeweiligen Substrate (W) zylindrisch geformte, konisch geformte oder scheibenförmige Elemente sind.

2. PVD-Verarbeitungsvorrichtung (1) nach Anspruch 1, worin der Tischdrehmechanismus (6) der PVD-Verarbeitungsvorrichtung (1) Folgendes beinhaltet:
ein zentrales Zahnrad (9) mit einer Zahnanordnung um die Drehachse (7) herum, wobei das zentrale Zahnrad (9) so befestigt ist, dass sich der Umlauftisch (3) relativ zu dem zentralen Zahnrad (9) drehen kann; und
eine Vielzahl von rotierenden Zahnrädern (10), die konfiguriert sind, um sich integral mit den jeweiligen Rotationstischen (4) um ihre jeweiligen Rotationsachsen zu drehen, wobei die rotierenden Zahnräder (10) um das zentrale Zahnrad (9) herum angeordnet sind, während sie mit dem zentralen Zahnrad (9) in Eingriff stehen, so dass die rotierenden Zahnräder (10) sich synchron mit der Drehung des Rotationstisches (3) um die Rotationsachse (7) auf ihren jeweiligen Rotationsachsen drehen können, und ein Übersetzungsverhältnis des Zentralgetriebes (9) zu jedem der rotierenden Zahnräder (10) so eingestellt ist, dass der Rotationstisch, auf dem das Substrat (W) angeordnet ist, um einen Winkel von 180° oder mehr relativ zum Umlauftisch (3) auf seiner Drehachse dreht, während das Substrat (W) durch einen Bereich zwischen den beiden Tangentiallinien (L1, L2) verläuft.

3. PVD-Verarbeitungsverfahren zum Durchführen einer Beschichtungsbildung auf entsprechenden Oberflächen einer Vielzahl von Substraten (W), wobei das PVD-Verarbeitungsverfahren umfasst:
Bereitstellen einer Vakuumkammer (2), die darin die Vielzahl von Substraten (W) enthält, eines Umlauftisches (3), der in der Vakuumkammer (2) vorgesehen und konfiguriert ist, um die Vielzahl von Substraten (W) zu tragen und die getragenen Substrate (W) um eine Umlaufachse (7) zu umlaufen, und einer Vielzahl von Zielen (5), die aus jeweiligen verschiedenen Arten von Beschichtungsmaterialien gebildet sind, wobei die Ziele an jeweiligen Positionen angeordnet sind, die in Umfangsrichtung auf radialer Ebene außerhalb des Umlauftisches (3) beabstandet sind;
**gekennzeichnet durch**
Durchführen einer PVD-Bearbeitung, bei der jedes der Substrate (W) um seine Drehachse um einen Winkel von 180° oder mehr relativ zum Umlauftisch (3) gedreht wird, während das Substrat (W) durch einen Bereich zwischen zwei Tangentenlinien (L1, L2) verläuft, die von einer Mitte jedes der Ziele zu einem Bogen gezogen werden, der jedes der Substrate (W) umgibt,
wobei die jeweiligen Substrate (W) zylindrisch geformte, konisch geformte oder scheibenförmige Elemente sind.

## Revendications

1. Un appareil de traitement PVD (1), pour effectuer une formation de revêtement sur des respectives surfaces d'une pluralité de substrats (W), l'appareil de traitement PVD (1) comprenant:
une chambre à vide (2) contenant à l'intérieur la pluralité de substrats (W);
une table tournante (3) prévue dans la chambre à vide (2) et configurée pour supporter la pluralité de substrats (W) et pour tourner les substrats supportés (W) autour d'un axe de révolution (7);
une pluralité de tables rotatives (4) configurées pour supporter de respectifs substrats (W) de la pluralité de substrats (W) et de tourner les substrats supportés (W) sur la table tournante (3) autour de leur axes de rotation parallèles par rapport à l'axe de révolution (7); et
une pluralité de cibles (5) formées de respectifs types différents de matériaux de formation de revêtements, les cibles étant distribuées à des respectives positions espacées de manière circonférentielle sur un radius hors la table tournante (3) ;
**caractérisé par**
un mécanisme de rotation de table (6) pour mettre en rotation chacune des tables rotatives (4) autour de son axe de rotation, le mécanisme de rotation de table (6) étant configuré pour mettre en rotation la table rotative, sur laquelle le substrat (W) est placée, autour de son axe de rotation par un angle de 180° ou plus par rapport à la table tournante (3) pendant que le substrat (W) passe à travers une région entre deux lignes tangentielles (L1, L2) dessinées à partir d'un centre de chacune des cibles (5) jusqu'à un arc (13) qui enveloppe les tables rotatives (4),
les respectifs substrats (W) étant des membres avec une forme cylindrique, conique ou de disque.

2. L'appareil de traitement PVD (1) selon la revendication 1, le mécanisme de rotation de table (6) de l'appareil de traitement PVD (1) incluant:
un engrenage central (9) ayant un agencement de dents autour de l'axe de révolution (7), l'engrenage central (9) étant fixé de manière à permettre que la table tournante (3) tourne par rapport à l'engrenage central (9); et
une pluralité d'engrenages rotatifs (10) configurés pour tourner intégralement avec les respectives tables rotatives (4) autour leur respectifs axes de rotation, les engrenages rotatifs (10) étant arrangés autour de l'engrenage central (9) et au même temps engageant l'engrenage central (9) afin de permettre que les engrenages rotatifs (10) tournent autour de leur respectifs axes de rotation de manière synchronisée avec la rotation de la table tournante (3) autour de l'axe de révolution (7), et un rapport de transmission de l'engrenage central (9) à chacun des engrenages rotatifs (10) étant fixé de sorte que la table rotative sur laquelle le substrat (W) est placée tourne sur son axe de rotation par un angle de 180° ou plus par rapport à la table tournante (3) pendant que le substrat (W) passe à travers une région entre les deux lignes tangentielles (L1, L2).

3. Un procédé de traitement PVD pour effectuer une formation de revêtement sur des respectives surfaces d'une pluralité de substrats (W), le procédé de traitement PVD (1) comprenant:
préparer une chambre à vide (2) contenant à l'intérieur la pluralité de substrats (W), une table tournante (3) prévue dans la chambre à vide (2) et configurée pour supporter la pluralité de substrats (W) et pour tourner les substrats supportés (W) autour de l'axe de révolution (7), et une pluralité de cibles (5) formées de respectifs types différents de matériaux de formation de revêtements, les cibles étant distribuées à des respectives positions espacées de manière circonférentielle sur un radius hors de la table tournante (3);
**caractérisé par**
effectuer le traitement PVD consistant à tourner chacun de substrats (W) autour de son axe de rotation par un angle de 180° ou plus par rapport à la table tournante (3) pendant que le substrat (W) passe à travers une région entre deux lignes tangentielles (L1, L2) dessinées à partir d'un centre de chacune des cibles (5) jusqu'à un arc qui enveloppe chacun des substrats (W),
les respectifs substrats (W) étant des membres cylindriques, coniques, ou en forme de disque. disque.ddddrique, conique ou de disque.
